Europäisches Patentamt

European Patent Office

Office européen des brevets

(19)

(11) Veröffentlichungsnummer: **0 183 893**
**B1**

(12) **EUROPÄISCHE PATENTSCHRIFT**

(45) Veröffentlichungstag der Patentschrift:
27.09.89

(51) Int. Cl.⁴: **G 01 R 19/155**

(21) Anmeldenummer: **85100708.8**

(22) Anmeldetag: **24.01.85**

(54) Prüfgerät zum Nachweis von Netzwechselspannungen und elektromagnetischen Wechselfeldern in der Umgebung spannungsführender Leiter.

(30) Priorität: 11.10.84 DE 3437320
27.10.84 DE 3439504

(43) Veröffentlichungstag der Anmeldung:
11.06.86 Patentblatt 86/24

(45) Bekanntmachung des Hinweises auf die Patenterteilung:
27.09.89 Patentblatt 89/39

(84) Benannte Vertragsstaaten:
AT BE CH DE FR GB IT LI LU NL SE

(56) Entgegenhaltungen:
DE-A- 3 004 734
DE-A- 3 104 527
DE-A- 3 108 974

(73) Patentinhaber: Schauerte, Hubertus, Freiheitstrasse 27,
D-5948 Schmallenberg 2 (DE)
Patentinhaber: Arens, Wolfgang, Obringhauser Weg 8,
D-5948 Schmallenberg 5 (DE)

(72) Erfinder: Schauerte, Hubertus, Freiheitstrasse 27,
D-5948 Schmallenberg 1 (DE)

(74) Vertreter: Patentanwälte TER MEER - MÜLLER -
STEINMEISTER, Artur-Ladebeck-Strasse 51,
D-4800 Bielefeld 1 (DE)

EP 0 183 893 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein elektrisches Prüfgerät gemäß dem Oberbegriff des Patentanspruchs 1 und ein elektrisches Vielfach-Meßgerät gemäß dem Oberbegriff des Patentanspruchs 9.

Aus der DE-A-30 04 734 ist ein als Schraubendreher ausgebildetes Prüfgerät mit den Merkmalen nach dem Oberbegriff des Anspruchs 1 bekannt. Bei diesem Prüfgerät wird das an der Prüfspitze anliegende Eingangssignal über einen hochohmigen Schutzwiderstand einer Darlington-Verstärkerschaltung zugeführt, die einen Verstärkungsfaktor von etwa $10^5$ aufweist. Durch einen zwischen die Prüfspitze und Masse geschalteten Teilerwiderstand wird die Empfindlichkeit des Darlington-Verstärkers definiert gemindert. Eine an dem Schraubendrehergriff angebrachte Berührungselektrode dient zur Erdung des Prüfgerätes über den Körper des Benutzers.

Dieses herkömmliche Prüfgerät zeichnet sich durch eine hohe Funktionssicherheit und eine relativ hohe Empfindlichkeit aus, so daß auch verhältnismäßig niedrige Spannungen in der Größenordnung von 40 bis 50 V noch deutlich angezeigt werden können.

Ein Nachweis von elektromagnetischen Wechselfeldern in der Umgebung spannungsführender Leiter ist mit einem solchen Gerät jedoch nicht möglich.

Aus der DE-CL-33 02 509 ist ein einpoliges Prüfgerät mit einer flexiblen Prüfspitze und einer Leuchtdiodenanzeige bekannt, das den Nachweis von Netzwechselspannungen und von induzierten Spannungen und ungeerdeten Leitern gestattet. Die Prüfspitze dieses herkömmlichen Prüfgerätes ist über einen hochohmigen Schutzwiderstand mit dem Eingang einer Darlington-Verstärkerschaltung verbunden, deren Emitter mit dem Minuspol einer Gleichspannungsquelle verbunden ist, während der Kollektor über die Leuchtdiode und einen Strombegrenzungswiderstand mit dem Pluspol der Spannungsquelle verbunden ist. Auf diese Weise können auch verhältnismäßig schwache induzierte Spannungen durch ein Aufleuchten der Leuchtdiode angezeigt werden, ohne daß eine Erdung des Prüfgerätes erforderlich ist. Der Eingang der Verstärkerschaltung ist ferner über einen Widerstand und einen Schalttransistor mit dem Minuspol der Spannungsquelle verbunden. Die Basis des Schalttransistors wird durch einen Rechteckgenerator angesteuert, so daß der Schalttransistor periodisch gesperrt und durchgesteuert wird. Bei durchgesteuertem Schalttransistor ist die Verstärkung so weit herabgesetzt, daß die Leuchtdiode nur noch bei Anliegen der vollen Netzwechselspannung aufleuchtet. Verhältnismäßig schwache Brummspannungen werden daher durch ein Blinken der Leuchtdiodenanzeige im Takt des Rechteckgenerators angezeigt, während die volle Netzwechselspannung durch ein dauerndes Aufleuchten der Leuchtdiode angezeigt wird. Auf diese Weise können die beiden Spannungsarten unterschieden werden, ohne daß ein manuelles Umschalten der Empfindlichkeit des Prüfgerätes erforderlich ist.

Mit Hilfe des herkömmlichen Prüfgerätes können auch elektromagnetische Wechselfelder in der Umgebung spannungsführender Leiter nachgewiesen werden. Dies hat den Vorteil, daß man die Prüfspitze außen an der Isolierung eines Leiters entlangführen und feststellen kann, in welchen Längenabschnitten der Leiter spannungsführend ist. Auf diese Weise können Unterbrechungen in einer elektrischen Leitung sehr einfach lokalisiert werden.

Zum Nachweis derartiger elektrischer Wechselfelder muß die flexible Prüfspitze ein oder mehrmals um den Leiter gewickelt werden, damit eine ausreichende Kopplung gewährleistet ist und in der Prüfspitze eine nachweisbare Spannung erzeugt wird. Dies hat den Nachteil, daß der Nachweis der Wechselfelder verhältnismäßig umständlich ist. Dieser Nachteil kann bei dem herkömmlichen Prüfgerät auch nicht durch eine Erhöhung der Empfindlichkeit überwunden werden, da sich in diesem Fall die Herabsetzung der Verstärkung mit Hilfe des Schalttransistors nicht so genau bemessen läßt, daß eine klare Unterscheidung zwischen Netzwechselspannung und induzierten Spannungen gewährleistet ist.

Aus der DE-CL-31 08 974 ist ein ähnliches Prüfgerät bekannt, bei dem anstelle des Schalttransistors eine Berührungselektrode vorgesehen ist, die zur Herabsetzung der Verstärkung bei direkten Messungen mit der Prüfspitze durch den menschlichen Körper geerdet wird. Für den Betrieb mit erhöhter Empfindlichkeit beim Nachweis elektromagnetischer Wechselfelder ist eine zweite Berührungselektrode vorgesehen. Bei diesem Stand der Technik besteht jedoch der gleiche Nachteil wie bei dem eingangs beschriebenen Prüfgerät.

Andererseits sind sogenannte Vielfach-Meßgeräte mit zwei Prüfspitzen bekannt, die eine quantitative Messung vor Spannungen, Strömen und Widerständen in unterschiedlichen Empfindlichkeitsbereichen gestatten. Mit derartigen Vielfach-Meßgeräten ist es bisher in der Regel nicht möglich, die Unterbrechung von spannungsführenden Leitern durch Abtastung der elektrischen Felder in der Umgebung des Leiters zu ermitteln.

Der Erfindung liegt die Aufgabe zugrunde, ein vielseitig einsetzbares und einfach zu bedienendes Meß- oder Prüfgerät zu schaffen, mit dem elektrische Wechselfelder in der Umgebung spannungsführender Leiter mühelos nachgewiesen werden können.

Erfindungsgemäße Lösungen dieser Aufgabe ergeben sich aus den Patentansprüchen 1 und 9.

Bei dem als Schraubendreher ausgebildeten Prüfgerät gemäß Anspruch 1 ist die Empfindlichkeit im Normalzustand so stark herabgesetzt (Verstärkungsfaktor ca. $10^4$), daß nur Netzwechselspannungen nachgewiesen werden. Das Gerät kann daher wie ein herkömmlicher, als Schraubendreher ausgebildeter Phasenprüfer eingesetzt werden. Wenn jedoch der Taster betätigt wird, steht die volle Verstärkung der Verstärkerschaltung zur Verfügung. Der Verstärkungsfaktor beträgt in diesem Fall wenigstens $10^6$, vorzugsweise $10^7$. Diese Verstärkung ist so hoch, daß selbst die schwachen Wechselfelder in der Umgebung spannungsführender Leiter nachgewiesen werden können, ohne daß die Prüfspitze um den Leiter geschlungen werden muß. Die Prüfspitze ist daher als starre Schraubendreherklinge ausgebildet.

Bevorzugt ist auf oder neben dem Taster eine Berührungselektrode angeordnet, die mit dem Pluspol der Gleichspannungsquelle verbunden ist und eine Durchgangsprüfung gestattet. Bei der Durchgangsprüfung wird gleichzeitig eine Batteriekontrolle durchgeführt, und durch den ständig auf ca. $10^4$ herabgesetzten Verstärkungsfaktor der Verstärkerschaltung werden Widerstände über 10 MΩ nicht mehr als Durchgang angezeigt. Bei Berühren der Berührungselektrode wird der Verstärkungsfaktor ($10^4$) bei der Durchgangsprüfung nicht erhöht. Nur durch extern zugeführte Wechselspannungen wird der Verstärkungsfaktor auf etwa $10^5$ erhöht, weil sich infolge der Verbindung durch den menschlichen Körper zur Erde ein größeres Potentialgefälle zwischen Eingang und Emitter der Verstärkerschaltung ergibt. Durch die höhere Verstärkung ($10^5$) können dann Brummspannungen angezeigt werden, wie sie in ungeerdeten Leitern auftreten.

Bei einem elektrischen Vielfach-Meßgerät wird die der Erfindung zugrunde liegende Aufgabe gemäß Anspruch 9 dadurch gelöst, daß in das Gerät eine Einrichtung zum Nachweis elektrischer Wechselfelder integriert ist, die eine im Inneren des Vielfach-Meßgerätes an einer Gehäuseaußenwand angeordnete Kupferplatte, eine über einen hohen Eingangswiderstand mit der Kupferplatte verbundene Verstärkerschaltung mit einem Verstärkungsfaktor von wenigstens $10^6$ und eine mit der Gleichspannungsquelle des Meßgerätes verbundene, durch die Verstärkerschaltung gesteuerte Leuchtdiode umfaßt.

Die Kupferplatte dient als Sonde zur Aufnahme von elektrischen Wechselfeldern. Das erfindungsgemäße Vielfach-Meßgerät ermöglicht somit zusätzlich zu quantitativen Strom-Spannungs-Widerstandsmessungen den qualitativen Nachweis von schwachen elektromagnetischen Wechselfeldern, wenn das Meßgerät an einem spannungsführenden Leiter entlanggeführt wird. Diese zusätzliche Funktion läßt sich unter weitgehender Ausnutzung von bereits in dem Meßgerät vorhandenen Bauteilen mit geringem baulichem Aufwand verwirklichen. Eine Herabsetzung des Verstärkungsfaktors ist bei dieser Ausführungsform der Erfindung nicht erforderlich, da Netzwechselspannungen in üblicher Weise durch eine quantitative Spannungsmessung nachgewiesen werden können.

Bervorzugt ist auch das Vielfach-Meßgerät mit einer Berührungselektrode zur Vereinfachung der Erdung des Gerätes während des Nachweises von Wechselfeldern versehen.

Bei sämtlichen Ausführungsformen der Erfindung kann anstelle der Leuchtdiode wahlweise ein akustischer Signalgeber vorgesehen sein.

Im folgenden wird ein bevorzugtes Ausführungsbeispiel der Erfindung anhand der Zeichnungen näher erläutert.

Fig. 1 und 2 sind perspektivische Darstellungen eines erfindungsgemäßen Prüfgerätes von zwei verschiedenen Seiten;

Fig. 3 zeigt eine Schaltskizze des Prüfgerätes gemäß Figuren 1 und 2.

Ein erfindungsgemäßes Prüfgerät 10 umfaßt eine als Schraubendreherklinge ausgebildete Prüfspitze 12 und einen Griff 14, der in seinem Inneren ein Batteriefach 16 und ein Elektrobauteilfach 18 aufweist. Auf einer Seitenfläche des Griffes 14 sind eine Leuchtdiode 20, eine Berührungselektrode 22 und ein Folientaster 24 angeordnet. Der Folientaster 24 und die Berührungselektrode 22 sind einander eng benachbart, so daß die Berührungselektrode bei Betätigung des Folientasters bequem mit berührt werden kann.

Das Batteriefach 16 nimmt eine Gleichspannungsquelle, beispielsweise eine Batterie 26 auf, die zur Spannungsversorgung einer in dem Elektrobauteilfach 18 untergebrachten elektrischen Schaltung dient.

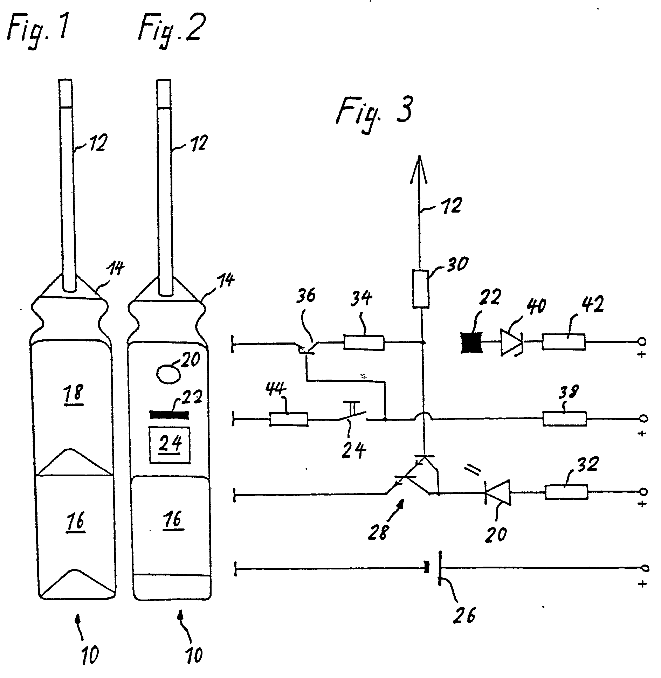

Die elektrische Schaltung umfaßt gemäß Figur 3 eine Darlington-Verstärkerschaltung 28, deren Eingang über einen Schutzwiderstand 30 mit der Prüfspitze 12 verbunden ist. Der Emitter der Verstärkerschaltung 28 ist mit Masse, d.h. mit dem Minuspol der Batterie 26 verbunden. Der Pluspol der Batterie ist über einen Strombegrenzungswiderstand 32 und die Leuchtdiode 20 mit dem Kollektor der Verstärkerschaltung verbunden.

Der Eingang der Verstärkerschaltung 28 steht über einen Widerstand 34 und einen Schalttransistor 36 mit Masse in Verbindung. Die Basis des Schalttransistors 36 ist über einen hochohmigen Basiswiderstand 38 mit dem Pluspol der Batterie 26 verbunden. Darüber hinaus ist die Basis mit Hilfe des Folientasters 24 über einen Widerstand 44 mit Masse verbindbar.

Die Berührungselektrode 22 ist über eine Zenerdiode 40 und einen Widerstand 42 mit dem Pluspol der Batterie verbunden.

Nachfolgend soll die Arbeitsweise des oben beschriebenen Prüfgerätes erläutert werden.

Wenn an der Prüfspitze 12 eine Netzwechselspannung von 220 Volt anliegt, so wird die Verstärkerschaltung 28 durch die positiven Halbwellen dieser Wechselspannung aufgesteuert, und es fließt ein durch den Widerstand 32 begrenzter Kollektorstrom, der die Leuchtdiode 20 zum Leuchten bringt. Wenn der Benutzer den Griff 14 des Prüfgerätes in der Hand hält, ist die kapazitive Kopplung so groß, daß eine Erdung des Prüfgerätes zum Nachweis von Netzwechselspannungen nicht erforderlich ist.

Der Schalttransistor 36 wird über den Basiswiderstand 38 positiv angesteuert und ist daher ständig leitend. Die Eingangsspannung der Verstärkerschaltung wird daher zum Teil über den Widerstand 34 abgeleitet, so daß die Verstärkung insgesamt herabgesetzt wird. Solange der Benutzer die Berührungselektrode 22 nicht berührt, werden daher Brummspannungen, wie sie in ungeerdeten Leitern erzeugt werden, nicht ausreichend verstärkt, so daß die Leuchtdiode 20 bei der Abtastung derartiger Spannungen dunkel bleibt.

Solche Brummspannungen können jedoch nachgewiesen werden, wenn der Benutzer die Berührungselektrode 22 berührt, da sich in diesem Fall ein größeres Potentialgefälle zwischen dem Eingang und dem Emitter der Verstärkerschaltung ergibt. Der Widerstandswert des Schutzwiderstands 30 beträgt etwa 10 MΩ. Durch die Wirkung dieses Schutzwiderstands, des ebenfalls sehr hochohmigen Widerstands 42 und der in Sperrichtung geschalteten Zenerdiode 40 wird der durch die Berührungselektrode und den menschlichen Körper fließende Strom auf einen sehr niedrigen Wert begrenzt. Das erfindungsgemäße Prüfgerät kann daher gefahrlos auch von Personen gehandhabt werden, die einen Herzschrittmacher tragen und deshalb besonders empfindlich auf Körperströme reagieren.

Zum Nachweis von Wechselfeldern in der Umgebung spannungsführender Leiter wird der Folientaster 24 betätigt, so daß die Basis des Schalttransistors 36 über eine durch die Widerstände 38 und 44 gebildete Spannungsteilerschaltung angesteuert wird. Da der Widerstand 44 im Verhältnis zu dem Widerstand 38 einen kleinen Widerstandswert aufweist, erhält die Basis in diesem Fall ein niedriges Potential, und der Schalttransistor 36 sperrt. Unter dieser Bedingung ergibt sich eine dem hohen Verstärkungsfaktor der Verstärkerschaltung 28 entsprechende hohe Gesamtverstärkung. Wenn gleichzeitig mit der Betätigung des Folientasters 24 die Berührungselektrode 22 berührt wird, so weist das Prüfgerät eine maximale Empfindlichkeit auf, und es können bereits geringste Spannungen nachgewiesen werden. Ein geringer Spannungsabfall über dem Widerstand 44 und dem pn-Übergang des Schalttransistors 36 führt dazu, daß der Eingang der Verstärkerschaltung 28 leicht positiv vorgespannt ist. Dies trägt zur Erhöhung der Empfindlichkeit des Prüfgerätes bei.

Das erfindungsgemäße Prüfgerät kann sowohl bei herabgesetzter als auch bei unverminderter Verstärkung zur Durchgangsprüfung eingesetzt werden. Zu diesem Zweck berührt der Benutzer eine Elektrode des auf Durchgang zu prüfenden Bauteils mit der Hand und die andere Elektrode mit der Prüfspitze 12, während er die Berührungselektrode 22 mit der Hand berührt. Ein Aufleuchten der Leuchtdiode 20 zeigt an, daß ein Strom von dem Pluspol der Batterie 26 über die Berührungselektrode 22, den menschlichen Körper, das zu prüfende Bauteil und die Prüfspitze 12 zum Minuspol der Batterie 26 fließt. Bei geöffnetem Folientaster 24 kann aufgrund der niedrigen Empfindlichkeit eine Durchgangsprüfung in der Weise durchgeführt werden, daß Widerstände von mehr als 10 MΩ nicht mehr als Durchgang angezeigt werden. Das Prüfgerät eignet sich daher besonders zur Funktionsprüfung von Halbleiterbauelementen. Andererseits kann durch Betätigen des Folientasters die Empfindlichkeit bei der Durchgangsprüfung erheblich erhöht werden, so daß beispielsweise eine Kondensatorprüfung durch Abtastung der geringen Ladeströme durchgeführt werden kann.

Bei dem erfindungsgemäßen Prüfgerät ist es aus Sicherheitsgründen wünschenswert, daß eine Möglichkeit zur Prüfung des Ladezustands der Batterie 26 besteht. Eine solche Batterieprüfung läßt sich in einfacher Weise durchführen, indem der Benutzer die Berührungselektrode 22 und zugleich die Prüfspitze 12 berührt. Wenn die Batterie 26 funktionsfähig ist, so leuchtet in diesem Fall die Leuchtdiode 20 auf. Wenn jedoch die Ausgangsspannung der Batterie 26 abnimmt, so sinkt der Spannungsabfall über der Zenerdiode 40 unter die Sperrspannung, so daß der Stromfluß unterbrochen wird und die Leuchtdiode 20 bei der Durchgangsprüfung nicht mehr aufleuchtet, während bei der Netzwechselspannungsprüfung noch eine volle Anzeige gewährleistet ist.

Die in Figur 3 gezeigte Schaltung kann in vereinfachter Form auch in einem Vielfach-Meßgerät vorgesehen sein, um einen einfachen qualitativen Nachweis elektromagnetischer Wechselfelder mit Hilfe eines solchen Meßgerätes zu ermöglichen. In diesem Falle wird die Prüfspitze 12 durch eine im Inneren des Gerätegehäuses an der Gehäusewand angeordnete Kupferplatte ersetzt. Da Netzwechselspannungen bei einem solchen Vielfach-Meßgerät in üblicher Weise durch quantitative Spannungsmessung nachgewiesen werden können, wird die Schaltung innerhalb des Vielfach-Meßgerätes nur mit maximaler Empfindlichkeit betrieben. Die zur Herabsetzung der Verstärkung dienenden Schaltelemente, nämlich die Widerstände 34, 38, 44, der Schalttransistor 36 und der Taster 24 können daher entfallen.

## Patentansprüche

1. Prüfgerät zum Nachweis von Netzwechselspannungen, mit einer Gleichspannungsquelle (26), einer Prüfspitze (12), die über einen Schutzwiderstand (30) mit dem Eingang einer Verstärkerschaltung (28) und ferner über einen Widerstand (34) mit Masse verbunden ist, und mit einem akustischen Signalgeber oder einer Leuchtdiode (20), der bzw. die mit der Gleichspannungsquelle verbunden und durch die Verstärkerschaltung gesteuert ist, wobei das Prüfgerät als Schraubendreher (10) ausgebildet ist, dessen Klinge die Prüfspitze (12) bildet und in dessen Griff (14) die elektrische Schaltung und die Gleichspannungsquelle untergebracht sind, gekennzeichnet durch einen Schalttransistor (36), der mit dem Widerstand (34) zwischen der Prüfspitze und Masse in Serie geschaltet ist und dessen Basis über Widerstände (38, 44) und einen Taster (24) derart angesteuert wird, daß der Schalttransistor bei Betätigung des Tasters sperrt, wodurch die Empfindlichkeit der Verstärkerschaltung so weit erhöht wird, daß elektromagnetische Wechselfelder in der Umgebung spannungsführender Leiter nachweisbar sind.

2. Prüfgerät nach Anspruch 1, dadurch gekennzeichnet, daß der Schalttransistor (36) ein npn-Transistor ist, dessen Emitter unmittelbar mit Masse verbunden ist und dessen Basis über einen Widerstand (38) ständig mit dem Pluspol der Spannungsquelle verbunden und über den Taster (24) und einen weiteren Widerstand (44) mit Masse verbindbar ist.

3. Prüfgerät nach Anspruch 2, gekennzeichnet durch eine mit der Gleichspannungsquelle (26) verbundene Berührungselektrode (22).

4. Prüfgerät nach Anspruch 3, dadurch gekennzeichnet, daß zwischen der Gleichspannungsquelle (26) und der Berührungselektrode (22) eine in Sperrrichtung geschaltete Zenerdiode (40) angeordnet ist, deren Sperrspannung kleiner als die Spannung der Gleichspannungsquelle ist.

5. Prüfgerät nach Anspruch 3 oder 4, dadurch gekennzeichnet, daß die Berührungselektrode (22) unmittelbar neben dem Taster (24) angeordnet ist.

6. Prüfgerät nach Anspruch 3 oder 4, dadurch gekennzeichnet, daß die Berührungselektrode auf dem Taster (24) angeordnet ist.

7. Prüfgerät nach einem der vorhergehenden Ansprüche, dadurch gekennzeichnet, daß der Taster (24) ein Folientaster ist.

8. Prüfgerät nach einem der vorhergehenden Ansprüche, dadurch gekennzeichnet, daß der Verstärkungsfaktor der Verstärkerschaltung bei geschlossenem Taster wenigstens 10⁶ beträgt.

9. Elektrisches Vielfach-Meßgerät mit einer Gleichspannungsquelle, gekennzeichnet durch eine Einrichtung zum Nachweis elektromagnetischer Wechselfelder, die eine im Inneren des Vielfach-Meßgerätes an einer Gehäuse-Außenwand angeordnete Kupferplatte, eine über einen hohen Eingangswiderstand mit der Kupferplatte verbundene Verstärkerschaltung mit einem Verstärkungsfaktor von wenigstens 10⁶ und einen akustischen Signalgeber oder eine Leuchtdiode umfaßt, der bzw. die mit der Gleichspannungsquelle des Meßgerätes verbunden und durch die Verstärkerschaltung gesteuert ist.

10. Prüfgerät nach Anspruch 9, gekennzeichnet durch eine mit der Gleichspannungsquelle verbundene Berührungselektrode.

**Claims**

1. Testing apparatus for detecting alternating current mains voltages, comprising a direct current voltage source (26), a testing tip (12) which is connected via a protective resistor (30) to the input of an amplifier circuit (28) and also to earth via a resistor (34), and with an acoustic signal generator or a light emitting diode (20) connected to the direct current voltage source and controlled by the amplifier circuit, the test apparatus being constructed as a screwdriver (10), the blade of which constitutes the test tip (12), the electric circuit and the direct current voltage source being accommodated in the handle (14), characterised by a switching transistor (36) connected in series with the resistor (34) between the test tip and earth and the base of which is so actuated by resistors (38, 44) and a button (24) that when actuated the switching transistor locks the button, so that the sensitivity of the amplifier circuit is sufficiently increased that electromagnetic alternating current fields in the ambient around live conductors can be detected.

2. Test apparatus according to Claim 1, characterised in that the switching transistor (36) is an npn transistor, the emitter of which is directly connected to earth and the base of which is connected via a resistor (38) constantly to the positive terminal of the voltage source and can be connected to earth via the button (24) and a further resistor (44).

3. Test apparatus according to Claim 2, characterised by a contact electrode (22) connected to the direct current voltage source (26).

4. Test apparatus according to Claim 3, characterised in that between the direct current voltage source (26) and the contact electrode (22) there is a zener diode (40) connected in the locking direction, the locking voltage of which is less than the voltage of the direct current voltage source.

5. Test apparatus according to Claim 3 or 4, characterised in that the contact electrode (22) is disposed immediately adjacent the button (24).

6. Test apparatus according to Claim 3 or 4, characterised in that the contact electrode is disposed on the button (24).

7. Test apparatus according to one of the preceding Claims, characterised in that the button (24) is a foil switch button.

8. Test apparatus according to one of the preceding Claims, characterised in that the amplification factor of the amplifier circuit is at least 10⁶ when the button is closed.

9. Electrical multiple measuring instrument with a direct current voltage source, characterised by a means of detecting electromagnetic alternating current fields and which comprises a copper plate disposed on an outside wall of the housing and in the interior of the multiple measuring instrument, an amplifier circuit connected to the copper plate via a high input resistance and having an amplification factor of at least 10⁶ and an acoustic signal generator or a light emitting diode which is connected to the direct current voltage source of the measuring instrument and is controlled by the amplifier circuit.

10. Test apparatus according to Claim 9, characterised by a contact electrode connected to the direct current voltage source.

**Revendications**

1. Appareil de contrôle pour indiquer des tensions de réseau alternatives, comprenant une source de tension continue (26), une pointe de contrôle (12) reliée à l'entrée d'un circuit amplificateur (28) par l'intermédiaire d'une résistance protectrice (30) et à la masse par l'intermédiaire d'une résistance (34), ainsi qu'un transmetteur de signaux acoustiques ou une diode électroluminescente (20) lequel et respectivement laquelle est relié(e) à la source de tension continue et commandé(e) par le circuit amplificateur, l'appareil de contrôle étant réalisé sous la forme d'un tournevis (10) dont la lame constitue la pointe de contrôle (12) et dont le manche (14) contient le circuit électrique et la source de tension continue, caractérisé en ce qu'il comprend un transistor de commutation (36) qui est monté en série avec la résistance (34) entre la pointe de contrôle et la masse et dont la base est commandée par l'intermédiaire des résistances (38, 44) et d'une touche (24) de telle façon que le transistor de commutation est bloqué lors de l'actionnement de la touche, ce qui entraîne une augmentation suffisante de la sensibilité du circuit amplificateur pour permettre la détection de champs alternants électromagnétiques à proximité de conducteurs sous tension.

2. Appareil de contrôle selon la revendication 1, caractérisé en ce que le transistor de commutation (36) est un transistor NPN dont l'émetteur est relié directement à la masse et dont la base est reliée en permanence, par l'intermédiaire d'une résistance (38), au pôle positif de la source de tension et peut être reliée à la masse par l'intermédiaire de la touche (24) et d'une autre résistance (44).

3. Appareil de contrôle selon la revendication 2, caractérisé en ce qu'il comprend une électrode de contact (22) reliée à la source de tension continue (26).

4. Appareil de contrôle selon la revendication 3, caractérisé en ce qu'entre la source de tension continue (26) et l'électrode de contact (22) est montée une diode Zener (40) montée dans le sens de non-conduction dont la tension inverse est inférieure à la tension de la source de tension continue.

5. Appareil de contrôle selon l'une des revendications 3 ou 4, caractérisé en ce que l'électrode de contact (22) est disposée immédiatement à côté de la touche (24).

6. Appareil de contrôle selon l'une des revendications 3 ou 4, caractérisé en ce que l'électrode de contact est montée sur la touche (24).

7. Appareil de contrôle selon l'une des revendications précédentes, caractérisé en ce que la touche (24) est une touche à effleurement.

8. Appareil de contrôle selon l'une des revendications précédentes, caractérisé en ce que le gain du circuit amplificateur est d'au moins $10^6$ lorsque la touche est enfoncée.

9. Contrôleur universel avec une source de tension continue, caractérisé en ce qu'il comprend un dispositif pour la détection de champs alternants électromagnétiques qui est muni d'une plaque de cuivre placée à l'intérieur du contrôleur universel sur une paroi extérieure du boîtier, d'un circuit amplificateur avec un gain d'au moins $10^6$ relié à la plaque de cuivre par l'intermédiaire d'une grande résistance d'entrée, et d'un transmetteur de signaux acoustiques ou d'une diode électroluminescente lequel et respectivement laquelle est relié(e) à la source de tension continue et commandé(e) par le circuit amplificateur.

10. Appareil de contrôle selon la revendication 9, caractérisé en ce qu'il comprend une électrode de contact reliée à la source de tension continue.

Fig.1   Fig.2

Fig. 3